(19) Europäisches Patentamt / European Patent Office / Office européen des brevets

(11) **EP 2 146 002 A1**

(12) **EUROPEAN PATENT APPLICATION**

(43) Date of publication:
**20.01.2010 Bulletin 2010/03**

(21) Application number: **08012850.7**

(22) Date of filing: **16.07.2008**

(51) Int Cl.:
*D06M 11/83* (2006.01)  *A01N 25/34* (2006.01)
*A01N 59/16* (2006.01)  *C23C 14/20* (2006.01)
*C23C 14/56* (2006.01)

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(71) Applicant: **Borealis AG**
**1220 Vienna (AT)**

(72) Inventors:
• **Broeders, Bert**
  **3550 Heusden (BE)**
• **Van Paridon, Henk**
  **3271 Averbode (BE)**
• **Ackermans, Nina**
  **3980 Tessenderlo (BE)**

(74) Representative: **Kador & Partner**
**Corneliusstrasse 15**
**80469 München (DE)**

(54) **Metal-coated polyolefin fibres for wovens and nonwovens**

(57)  The present invention is directed to a thermal vaporization process for coating of polyolefin fibres with a metal, wherein said process comprises the following steps:
- inserting a polyolefin fibre or a sample of polyolefin fibres into a metallisation chamber comprising a heating means located next to a piece of metal,
- applying a high vacuum in said chamber
- applying heat by said heating means to said piece of metal whereby the metal evaporates and is deposited onto the colder surface of said polyolefin fibre or sample of polyolefin fibres
- removing the coated fibre or sample of fibres from said metallisation chamber.

Similarly, the present invention is also directed to said process applied on wovens or nonwovens.

The present invention is further directed to polyolefin fibres coated with a metal according to the inventive process, to wovens and nonwovens coated by the inventive process and to polyolefin fibres, wovens and nonwovens having a surface coating of metal, wherein said surface coating has a thickness of between 0.1 to 100 nm.

EP 2 146 002 A1

**Description**

The present invention relates to a process for coating polyolefin fibres with a metal, and to the product of such a process, namely a metal-coated polyolefin fibre, and further to wovens or nonwovens comprising said metal-coated polyolefin fibers.

It is known that silver is used to award several articles antimicrobial properties. Particularly, it is known that such antimicrobial properties are typically achieved for articles made of polyolefins by means of silver-based masterbatches, i.e. the polyolefin is compounded with a masterbatch containing silver particles. Due to the size of said silver particles the application of such silver particles is limited. Having a particle size of about 1 $\mu$m, such a particle is too large for very fine fibres which itself have a very small diameter. The diameter of a fine polyolefin fibre may be typically less than 2 $\mu$m. Adding a masterbatch containing silver particles as described above to a polyolefin composition and producing such a fine fibre thereof causes problems in the process of producing the fibre and may also cause problems in case of a process of spinning the fibres to yarns for wovens respectively. Further on, a poor distribution of said particles in said fibre results. Hence, there is a strong need for a technique which allows to make fine fibres and thereby wovens or nonwovens antimicrobial.

In this regard it has been suggested to incorporate nanosilver components which however are rather expensive. Hence, there is also a need for a cheaper technique which allows to make fine fibres antimicrobial.

A survey of antibacterial activity of polypropylene compounded with nano-sized silver powders is given in Journal of Materials Science 2006, 40, 20, 5407-5411.

It is also known to coat a substrate with silver by using a chemical reaction wherein cations of silver are reduced by organic reducing agents. A study of antibacterial properties of silver nano-coated cotton fabrics received by such a chemical reaction is described in "A practical procedure for producing silver nanocoated fabric and its antibacterial evaluation for biomedical applications" (Chem. Commun. (Camb). 2007 Jul 28;(28):2959-61. Epub 2007 May 18). A similar study is given in Textile Research Journal 2006, 76, 57-65. The disadvantage of such processes is that apart from the silver layer further products result from the chemical reaction which have to be separated and involve further effort which should be avoided in a technical process due to the costs involved.

It is further known to coat fabrics with silver by using a plasma-process or plasma-sputtering process. Such a process is described in Curr. Probl. Dermatol. 2006, 33, 179-199. A disadvantage of this process is again the high costs that are involved.

Hence, there is still a need for a reliable and cheap process which makes polyolefin fibres antimicrobial.

However, not only a process of adding silver to polyolefin fibres in view of antimicrobial properties is desirable. There are many applications thinkable for polyolefin fibres as well as wovens or nonwovens comprising said polyolefin fibres wherein the addition of silver or a metal other than silver is needed. Examples are filter media with permanent electrical charge for combined mechanical filtration and charged attraction or electrical conductivity and anti-static performance in general as well as thermal insulation and heat reflection. In case antimicrobial properties are not needed, e.g. aluminium could be desirable.

The problem is again to provide a reliable and comparably cheap process for adding a metal to a polyolefin fibre which process does not affect the process of producing the polyolefin fibre or rather the process of spinning.

It is finally known to coat biaxially orientated polypropylene (BOPP) films with a metal by a thermal vaporization process. This process is widely used in the packaging industry. However, the BOPP films have to be pretreated by either corona or flame treatments. Said pretreatment is absolutely necessary since otherwise the metal does not adhere on the film surface. This pre-treatment is done in-line in the film production. A disadvantage of said pretreatment is that it generates additional costs. In case of non-wovens the prorosity would not allow a corona treatment.

The above-mentioned problems are solved by a process according to claim 1 which describes the surface coating of a polyolefin fibre with a metal.

It has been surprisingly found that surface coating of polyolefin fibres is possible by a thermal vaporization process without the need of a pretreatment as required for BOPP films.

Accordingly, the present invention provides a thermal vaporization process for coating of polyolefin fibres with a metal, wherein said process comprises the following steps:

-    inserting a polyolefin fibre or a sample of polyolefin fibres into a metallisation chamber comprising a heating means located next to a piece of metal,

-    applying a high vacuum in said chamber

-    applying heat by said heating means to said piece of metal whereby the metal evaporates and is deposited onto the colder surface of said polyolefin fibre or sample of polyolefin fibres

- removing the coated fibre or sample of fibres from said metallisation chamber.

With the inventive process it is possible to provide polyolefin fibres comprising metal atoms without negatively affecting the process of producing the polyolefin fibres. One further advantage of the inventive process is that the metal atoms are only at the location where they should be for awarding antimicrobial, antistatic or rather electrical properties to the polyolefin fibre or rather the woven or nonwoven, namely on the surface of the polyolefin fibres. Hence, no metal is "lost" which is inside the bulk of the polyolefin fibre and has therefore no effect as regards said properties of the polyolefin fibre. As a consequence, less metal can be used compared to known processes using a metal masterbatch. Therefore, the inventive process provides a cheaper and also more effective alternative to the known processes using metal masterbatches. Finally, the thermal vaporization process is also cheaper than plasma sputtering and does not have any problems of by-products as in chemical coating reactions.

There is also a great advantage in view of a process wherein silver particles are compounded with the polyolefin composition from a practical point of view: No transition in the fibre production process is necessary. Instead, the metalliser can simply be switched on or off while using a metal masterbatch it is necessary to purge the line if the product is changed from fibres containing a metal masterbatch to fibres which do not contain such a masterbatch. Further on, using the inventive process the equipment already available for surface coating of BOPP films may be used.

In a preferred embodiment of the inventive process said sample of polyolefin fibres is a woven or nonwoven comprising said polyolefin fibres.

The inventive process may be carried out with any metal which is able to be coated onto a polyolefin fibre and the inventive process can be performed with. A thermal vaporization process is known to be generally applicable with aluminium, copper, silver and zinc. However, the inventive process is not restricted to these metals. The metals that can be used depend on the thermal vaporization temperature of the respective metal and on the pressure in the metallisation chamber. Further on, the vapour pressure of the metal to be used must be considerably higher than the vapour pressure of the material the heating means is made of. Otherwise contamination of the metal layer to be produced with the material of the heating means has to be expected.

A particularly preferred metal to be used is silver. A further very preferred metal is aluminium.

Preferably the heating means is an electric resistance heater, more preferably a metal spiral.

Preferably the heating means is made of steel.

Still preferably the metal to be coated onto the polyolefin fibre is either silver or aluminium.

Preferably the piece of metal is a wire.

Preferably the pressure in the metallisation chamber under high vacuum is between 1 to 10 mPa, more preferably between 3 to 7 mPa.

The inventive process is preferably run batchwise.

This means that a polyolefin fibre, sample of polyolefin fibres, a woven or a nonwoven is placed into a sealed-off metallisation chamber. The chamber is closed and high vacuum is applied. Afterwards heating with the heating means is started. After a given time the heating is stopped and the metallisation chamber is vented. The time of heating depends on the dimensions of the substrate to be coated with metal.

Preferably, the substrate - a fibre, a woven or nonwoven - is provided in a furled manner. The substrate is unwound in the metallisation chamber under the metallisation conditions, runs over the metal vapour that is generated in the metallization chamber and is coiled up at the other side. The polyolefin substrate coated with metal is removed and the metallisation chamber is ready for a new cycle.

In a preferred embodiment the process is carried out with a fibre made of a polypropylene composition or of a polyethylene composition, including copolymers of propylene or ethylene with other alpha-olefins comprising from 3 to 6 carbon atoms.

It is further preferred that the polyolefin composition comprises, more preferable consists of a polyethylene composition or a polypropylene composition. Most preferred is that the polyolefin composition is a polypropylene composition.

The polyolefin composition, if it is predominantly or exclusively comprised of polypropylene, which is to be used for the polyolefin fibre to be treated with metal according to the present invention, preferably has an $MFR_2$ (230°C) of between 12 and 3000 g/10 min, more preferably between 12 and 2000 g/10 min.

The polyolefin composition, if it is predominantly or exclusively comprised of polyethlyene, which is to be used for the polyolefin fibre to be treated with metal according to the present invention, preferably has an $MFR_2$ (190°C) of between 0.2 and 1000 g/10 min, more preferably between 0.4 and 500 g/10 min.

A polyolefin fibre to be coated according to the present invention has a diameter of preferably 0.1 to 30 $\mu$m, more preferably of 1 to 10 $\mu$m.

The polyolefin composition may comprises additives, i.e. stabilizers and modifiers. Typical stabilizers are antioxidants, typical modifiers are anti-static and anti-fogging agents, acid scavengers, blowing agents, lubricants, nucleating agents, slip and anti-blocking agents, as well as fillers, flame retardants and cross-linkers. The polyolefin composition may also comprise pigments.

It is further preferred that the nonwovens according to the invention are received from polyolefin fibres by meltblown, spunbond, spunbond-meltblown-spunbond (SMS), carding, airlaid or any other web formation process.

It is further preferred that the wovens according to the invention are received from polyolefin fibres by meltblown or spunbond processes.

The present invention is also directed to a polyolefin fibre which is coated with a metal according to the inventive process, to a woven or nonwoven coated with the inventive process, said woven or nonwoven made from polyolefin fibres, and to a woven or nonwoven made from polyolefin fibres, wherein said polyolefin fibres where coated with the inventive process before.

The products of the inventive process show only a coating of metal on the fibres. If the process is not applied on a single fibre or a sample of fibres but on a woven or nonwoven, the pores between said fibres are not covered with metal resulting in a breathable metallised structure, e.g. a fabric.

As regards the type of polyolefin composition and the fibres, the woven or nonwoven, as well as the metal used for coating, the same preferred embodiments apply as for the inventive process.

The present invention is also directed to a polyolefin fibre comprising a surface coating of metal with a thickness of between 0.1 to 100 nm, to a woven or nonwoven made from such coated polyolefin fibres and to a woven or nonwoven comprising polyolefin fibres wherein the surface of said polyolefin fibres is coated with a metal and the thickness of said coating is between 0.1 to 100 nm.

As regards the type of polyolefin composition and the fibres, the woven or nonwoven, as well as the metal used for coating, the same preferred embodiments apply as for the inventive process.

Measurement methods

a) Melt Flow Rate

The melt flow rate (MFR) is determined according to ISO 1133 and is indicated in g/10 min. The MFR is an indication of the melt viscosity of the polymer. The MFR is determined at 190°C for PE and at 230°C for PP. The load under which the melt flow rate is determined is usually indicated as a subscript, for instance $MFR_2$ is measured under 2.16 kg load.

b) Density

The density of polymer compositions was measured according to ISO 1183/D.

c) Determination of antibacterial activity

The tests where performed according to ISO/FDIS 20743 : 2007. These tests are used to quantitatively measure the antimicrobial activity of antibacterial finished samples.

The test samples (inventive, silver coated) and control samples (comparative, no metal coating) are cut into pieces of 3.8 cm in diameter. Afterwards the inoculation is performed by transfer of bacteria from agar plate onto the samples. Each test sample as well as each control sample is placed on the agar surface of an agar plate that has been previously inoculated by first flooding the agar surface with 1 ml of a bacterial suspension adjusted to a concentration of $1 \times 10^6$ to $3 \times 10^6$ CFU/ml and then sucking up as much of the excess liquid as possible. A weight of 200 g is applied on the sample for 60 seconds and the sample is afterwards placed in a petri dish with the transferred surface face up.

Six test samples in individual petri dishes plus six separate petri dishes with control samples constitute one test.

Immediately after transfer (so-called "0 contact time"), three of the six test samples and three of the six control samples are each placed in a vial containing a neutralizing solution (one vial/sample) and are shaken out to extract the bacteria present on them. A counting of the extraction liquid is performed by the Plate Count Method.

The remaining test samples and control samples are incubated in their petri dishes in a humidity chamber at 37 °C for 18 to 24 hours.

After incubation, extraction and counting of the bacteria present on the remaining test samples or rather control samples is performed as described above for the "0 contact time". The growth value and the activity values are computed afterwards.

The growth value is computed as follows:

$$F = C_t - C_0$$

$F$ :    growth value of the control sample

$C_t$ :    average of decadic logarithms of the number of bacteria obtained from three control samples after 18 to 24 hours incubation

$C_0$ :    average of decadic logarithms of the number of bacteria obtained from three control samples immediately after transfer to the control samples

The test is judged to be effective, if the growth value is > 1 for the control sample and if the logarithm of the difference in extremes of the value of number of bacteria for the three control samples immediately after transfer as well as after incubation is not more than 1.
The activity value is computed as follows:

$$A = (C_t - C_0) - (T_t - T_0) = F - G$$

$A$ :    antibacterial activity value

$F$ :    growth value of the control sample

$G$ :    growth value of the test sample

$T_t$ :    average of decadic logarithms of the number of bacteria obtained from three test samples after 18 to 24 hours incubation

$T_0$ :    average of decadic logarithms of the number of bacteria obtained from three test samples immediately after transfer to the test samples

Examples

a) Preparation of meltblown samples

Meltblown fabric samples were produced on a REICOFIL® MB 250 meltblown laboratory line using a propylene homopolymer having an $MFR_2$ (230°C) of 1200 g/10 min. Line speed of the meltblown line was 10 m/min, corresponding with a throughput of 30 kg/(m · min) and resulting in an area weight of ca. 50 g/m$^2$. The average fiber diameter was 5 μm (range of 4-6 μm).

b) Step of metallisation

Samples from the meltblown line have been metallised with silver using a laboratory metalliser (AUTO 306 Coater of the brand Edwards having a FL400 vacuum chamber with see-through window and 10 volts transformer).
A flat sheet of substrate (meltblown nonwoven) to be coated with a metal is cut to fit into a metal holder. Said holder consists of two steel frames that fit into each other. The substrate is clamped between the frames and is such stabilized.
The holder with the substrate is placed into the metallisation chamber. Within said metallisation chamber there is a steel spiral that can be heated by an electric current. A piece of a metal wire of the material to be deposited with a weight of 75 mg +/- 1 mg is inserted inside said spiral.
The chamber is closed and brought under high vacuum. As soon as the pressure in the chamber reaches 6.5 $\times$ 10$^{-5}$ mbar, the steel spiral is heated. The wire (aluminium or silver) evaporates and is deposited onto colder surfaces as the substrate. The evaporation is allowed to take place 10 seconds.
Afterwards the heating of the steel spiral is (automatically) switched off and the pressure is brought to atmospheric pressure by venting the chamber. Finally, the metallised sample is removed.

c) Antimicrobial performance of silver-coated samples

The antimicrobial performance of samples coated with silver as described under paragraph a) above has been tested by Centexbel. (Centexbel is a certified laboratory. Centexbel is the scientific and technological research centre of the Belgian textile industry.) As a result the substrate treated with silver showed good antimicrobial activity against Staphylococcus aureus and Klebsiella pneumoniae as will be explained in detail below.

The strains used in the Examples were the following:

Klebsiella pneumoniae ATCC 4352

Staphylococcus aureus ATCC 6538

The test was performed as described above under measurement methods, c). In addition to the six test samples and the six control samples also an internal control with a cotton fabric (200 g/m$^2$) has been used (EMPA Nr. 221, which is a commercially available testfabric, which is 100 % cotton-based).

1 ml of the inoculum solution was used to flood the agar surface of the transfer agar plate: Peptone-salt solution (Tryptone, pancreatic digest of casein: 1 g/l, NaCl: 8.5 g/l), 1 ml was used.

20 ml of the neutralizing solution was used: Polysorbate 80: 30 g/l, Lecithin: 3 g/l, Histidine hydrochloride: 1 g/l, Peptone: 1 g/l, NaCl: 4.3 g/l, Mono-potassium phosphate: 3.6 g/l, Disodium phosphate dihydrate: 7.2 g/l.

The contact time was 18 hours (at 37 °C).

Microbiological technique used for the determination of the viable cells: count of number of colonies of dilution series on Petri dishes (Plate Count Method).

Example 1

The tests were performed with Staphylococcus aureus ATCC 6538. The inoculum concentration was 2.6 × 10$^6$ CFU/ml.

Table 1 shows the control of the growth value obtained on the control samples (CFU: colony forming unit).

Table 2 shows the count of bacteria on the samples, both growth values and the resulting antibacterial activity value.

Table 1:

| Sample | Trial | 0 contact time | | 18 hours | contact time |
|---|---|---|---|---|---|
| | | CFU | $\log_{10}$(CFU) | CFU | $\log_{10}$(CFU) |
| Control | 1 | 3.2 × 10$^5$ | 5.51 | 2.8 × 10$^6$ | 6.45 |
| Control | 2 | 3.8 × 10$^5$ | 5.58 | 2.2 × 10$^6$ | 6.34 |
| Control | 3 | 3.6 × 10$^5$ | 5.56 | 2.2 × 10$^6$ | 6.34 |
| Average | | | 5.6 ± 0.04 | | 6.4 ± 0.06 |
| Growth value | $F$ | | | | 0.8 |
| Internal control | 1 | 3.6 × 10$^5$ | 5.56 | 1.1 × 10$^7$ | 7.03 |
| | 2 | 4.2 × 10$^5$ | 5.62 | 1.9 × 10$^7$ | 7.27 |
| Average | | | 5.6 ± 0.04 | | 7.2 ± 0.17 |
| Growth value | $F$ | | | | 1.6 |

The growth value of the control samples is a little bit too low but still acceptable.

Table 2:

| Sample | Trial | 0 contact time | | 18 hours | contact time |
|---|---|---|---|---|---|
| | | CFU | $\log_{10}$(CFU) | CFU | $\log_{10}$(CFU) |
| Control | 1 | 3.2 × 10$^5$ | 5.51 | 2.8 × 10$^6$ | 6.45 |
| Control | 2 | 3.8 × 10$^5$ | 5.58 | 2.2 × 10$^6$ | 6.34 |
| Control | 3 | 3.6 × 10$^5$ | 5.56 | 2.2 × 10$^6$ | 6.34 |

(continued)

| Sample | Trial | 0 contact time | | 18 hours | contact time |
|---|---|---|---|---|---|
| | | CFU | $\log_{10}$(CFU) | CFU | $\log_{10}$(CFU) |
| Average | | | $5.6 \pm 0.04$ | | $6.4 \pm 0.06$ |
| Growth value | $F$ | | | | 0.8 |
| | 1 | $3.4 \times 10^5$ | 5.53 | $0^1$ | $0^1$ |
| | 2 | $4.0 \times 10^5$ | 5.60 | $0^1$ | $0^1$ |
| | 3 | $3.6 \times 10^5$ | 5.56 | $0^1$ | $0^1$ |
| Average | | | $5.6 \pm 0.04$ | | 0 |
| Growth value | $G$ | | | | -5.6 |
| Antibacterial activity $A$ | | | | | 6.4 |

[1] "0" means that no colony has been counted. If no colony is counted, $\log_{10}$(CFU) is arbitrarily fixed to "0".

Example 2

The tests were performed with Klebsiella pneumoniae ATCC 4352. The inoculum concentration was $2.5 \times 10^6$ CFU/ml.

Table 3 shows the control of the growth value obtained on the control samples (CFU: colony forming unit).

Table 4 shows the count of bacteria on the samples, both growth values and the resulting antibacterial activity value.

Table 3:

| Sample | Trial | 0 contact time | | 18 hours contact time | |
|---|---|---|---|---|---|
| | | CFU | $\log_{10}$(CFU) | CFU | $\log_{10}$(CFU) |
| Control | 1 | $2.0 \times 10^5$ | 5.30 | $7.4 \times 10^5$ | 5.87 |
| Control | 2 | $1.8 \times 10^5$ | 5.25 | $3.6 \times 10^5$ | 5.56 |
| Control | 3 | $1.9 \times 10^5$ | 5.28 | $2.8 \times 10^6$ | 6.45 |
| Average | | | $5.3 \pm 0.03$ | | $6.0 \pm 0.45$ |
| Growth value $F$ | | | | | 0.7 |
| Internal control | 1 | $2.0 \times 10^5$ | 5.29 | $2.4 \times 10^8$ | 8.38 |
| | 2 | $2.4 \times 10^5$ | 5.38 | $9.0 \times 10^7$ | 7.95 |
| Average | | | $5.3 \pm 0.06$ | | $8.2 \pm 0.30$ |
| Growth value $F$ | | | | | 2.9 |

The growth value of the control samples is a little bit too low but still acceptable.

Table 4:

| Sample | Trial | 0 contact time | | 18 hours contact time | |
|---|---|---|---|---|---|
| | | CFU | $\log_{10}$(CFU) | CFU | $\log_{10}$(CFU) |
| Control | 1 | $2.0 \times 10^5$ | 5.30 | $7.4 \times 10^5$ | 5.87 |
| Control | 2 | $1.8 \times 10^5$ | 5.25 | $3.6 \times 10^5$ | 5.56 |
| Control | 3 | $1.9 \times 10^5$ | 5.28 | $2.8 \times 10^6$ | 6.45 |
| Average | | | $5.3 \pm 0.03$ | | $6.0 \pm 0.45$ |
| Growth value $F$ | | | | | 0.7 |
| | 1 | $1.6 \times 10^5$ | 5.20 | $0^1$ | $0^1$ |
| | 2 | $1.1 \times 10^5$ | 5.04 | $0^1$ | $0^1$ |
| | 3 | $2.0 \times 10^5$ | 5.30 | $0^1$ | $0^1$ |
| Average | | | $5.2 \pm 0.13$ | | 0 |
| Growth value $G$ | | | | | -5.2 |

(continued)

| Sample | Trial | 0 contact time | | 18 hours contact time | |
|---|---|---|---|---|---|
| | | CFU | $\log_{10}(CFU)$ | CFU | $\log_{10}(CFU)$ |
| Antibacterial activity $A$ | | | | | 5.9 |

[1] "0" means that no colony has been counted. If no colony is counted, $\log_{10}(CFU)$ is arbitrarily fixed to "0".

**Claims**

1. A thermal vaporization process for coating of polyolefin fibres with a metal, wherein said process comprises the following steps:

   - inserting a polyolefin fibre or a sample of polyolefin fibres into a metallisation chamber comprising a heating means located next to a piece of metal,
   - applying a high vacuum in said chamber
   - applying heat by said heating means to said piece of metal whereby the metal evaporates and is deposited onto the colder surface of said polyolefin fibre or sample of polyolefin fibres
   - removing the coated fibre or sample of fibres from said metallisation chamber.

2. The process according to claim 1, wherein said sample of polyolefin fibres is a woven or nonwoven comprising said polyolefin fibres.

3. The process according to claims 1 or 2, wherein the metal is silver.

4. The process according to claims 1 or 2, wherein the metal is aluminium.

5. The process according to any one of the preceding claims, wherein said heating means is an electric resistance heater.

6. The process according to any one of the preceding claims, wherein the pressure in said metallisation chamber under high vacuum is between 1 to 10 mPa.

7. The process according to any one of the preceding claims, wherein the fibre to be coated with metal is made of a polypropylene composition or of a polyethylene composition, including copolymers of propylene or ethylene with other alpha-olefins comprising from 3 to 6 carbon atoms.

8. The process according to any one of the preceding claims, wherein the diameter of the polyolefin fibre to be coated is from 0.1 to 30 $\mu$m.

9. A polyolefin fibre or sample of polyolefin fibres coated with a metal received by a process according to any one of claims 1 to 8.

10. A woven or nonwoven coated with a metal received by a process according to any one of claims 2 to 8.

11. A woven or nonwoven made from a polyolefin fibre according to claim 9.

12. A polyolefin fibre coated with a metal on the surface, wherein said surface coating with metal has a thickness of between 0.1 to 100 nm.

13. A woven or nonwoven made from a polyolefin fibre according to claim 12.

14. A woven or nonwoven comprising polyolefin fibres coated with a metal on the surface, wherein said surface coating with metal on said polyolefin fibres has a thickness of between 0.1 to 100 nm.

## EUROPEAN SEARCH REPORT

**Application Number**

EP 08 01 2850

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DE 21 46 103 A1 (LENTIA GMBH) 22 March 1973 (1973-03-22) * page 2, line 1 - line 16 * * page 4, line 8 - line 10 * * page 4, line 18 - page 5, line 4 * * page 6, line 1 - line 10; example 1 * ----- | 1-4,7, 9-14 | INV. D06M11/83 A01N25/34 A01N59/16 C23C14/20 C23C14/56 |
| X | US 5 316 837 A (COHEN BERNARD [US]) 31 May 1994 (1994-05-31) * column 4, line 43 - line 60 * * column 5, line 26 - line 32 * * column 13, line 49 - line 60 * * column 14, line 28 - line 68 * ----- | 1-11 | |

**TECHNICAL FIELDS SEARCHED (IPC)**

D06M
A01N

The present search report has been drawn up for all claims

| Place of search | Date of completion of the search | Examiner |
|---|---|---|
| The Hague | 20 January 2009 | Menard, Claire |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 08 01 2850

This annex lists the patent family members relating to the patent documents cited in the above-mentioned European search report.
The members are as contained in the European Patent Office EDP file on
The European Patent Office is in no way liable for these particulars which are merely given for the purpose of information.

20-01-2009

| Patent document cited in search report | | Publication date | Patent family member(s) | | Publication date |
|---|---|---|---|---|---|
| DE 2146103 | A1 | 22-03-1973 | NONE | | |
| US 5316837 | A | 31-05-1994 | AU | 670664 B2 | 25-07-1996 |
| | | | AU | 5767394 A | 15-09-1994 |
| | | | CA | 2101834 A1 | 10-09-1994 |
| | | | DE | 69414436 D1 | 17-12-1998 |
| | | | DE | 69414436 T2 | 08-04-1999 |
| | | | EP | 0615015 A1 | 14-09-1994 |
| | | | JP | 6299457 A | 25-10-1994 |
| | | | ZA | 9400577 A | 13-09-1994 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- *Journal of Materials Science,* 2006, vol. 40 (20), 5407-5411
- A practical procedure for producing silver nanocoated fabric and its antibacterial evaluation for biomedical applications. *Chem. Commun. (Camb).,* 18 May 2007, 2959-61

- *Textile Research Journal,* 2006, vol. 76, 57-65
- *Curr. Probl. Dermatol.,* 2006, vol. 33, 179-199